(19) Europäisches Patentamt / European Patent Office / Office européen des brevets

(11) **EP 4 118 518 B1**

(12) **EUROPÄISCHE PATENTSCHRIFT**

(45) Veröffentlichungstag und Bekanntmachung des Hinweises auf die Patenterteilung:
**12.07.2023   Patentblatt 2023/28**

(21) Anmeldenummer: **22729477.4**

(22) Anmeldetag: **13.05.2022**

(51) Internationale Patentklassifikation (IPC):
*G06F 3/041* (2006.01)          *H03K 17/96* (2006.01)

(52) Gemeinsame Patentklassifikation (CPC):
**G06F 3/04186; H03K 17/9622;** H03K 2217/94036;
H03K 2217/960705

(86) Internationale Anmeldenummer:
**PCT/EP2022/062998**

(87) Internationale Veröffentlichungsnummer:
**WO 2022/248243 (01.12.2022 Gazette 2022/48)**

(54) **VERFAHREN ZUR SIGNALAUSWERTUNG**

SIGNAL EVALUATION METHOD

PROCÉDÉ D'ÉVALUATION DE SIGNAUX

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.05.2021   DE 102021002801**

(43) Veröffentlichungstag der Anmeldung:
**18.01.2023   Patentblatt 2023/03**

(73) Patentinhaber: **Mercedes-Benz Group AG**
**70372 Stuttgart (DE)**

(72) Erfinder:
• **MÖRZ, Sebastian**
  **71063 Sindelfingen (DE)**

• **OEHMEN, Jürgen**
  **76228 Karlsruhe (DE)**
• **WINKLER, Matthias**
  **73669 Lichtenwald (DE)**

(74) Vertreter: **Novagraaf Group**
**Chemin de l'Echo 3**
**1213 Onex / Geneva (CH)**

(56) Entgegenhaltungen:
WO-A1-2014/143200          US-A1- 2011 205 177
US-A1- 2013 093 715          US-A1- 2014 160 060
US-B2- 9 069 417

**Beschreibung**

Die Erfindung betrifft ein Verfahren zur Signalauswertung von über einen Finger getätigten Eingaben auf einem berührungsempfindlichen kapazitiven Bedienelement. Außerdem betrifft die Erfindung ein berührungsempfindliches Bedienelement zur Durchführung des Verfahrens.

Beispielsweise aus der US 2010/022909 A1 ist eine Sensorfläche eines berührungsempfindlichen Bedienelements bekannt, bei der eine Fingerposition als Schwerpunkt aus verschiedenen Sensorsignalen ermittelt wird. Bei vergleichsweise großflächigen berührungssensitiven Elementen ist diese Lösung durchaus akzeptabel. Bei kleineren Touchpads, welche beispielsweise zur Einstellung der Lautstärke einer Medienanlage verwendet werden können oder dergleichen, kann dies jedoch kritisch sein, ebenso wie bei Eingaben mit relativ kleinen Bewegungsradien des Fingers. Bei einer entsprechend flächigen Auflage des Fingers führt dies nämlich dazu, dass verschiedene Sensoren innerhalb der Fläche angeregt werden, wobei die Unterschiede in den Sensorhüben dieser Sensoren relativ klein sind, sodass bereits eine geringe Verkippung oder eine Abrollbewegung des Fingers zu einer ungewollten Verschiebung einer aus den Sensorhüben bzw. ihrem Schwerpunkt oder Flächenmittelpunkt berechneten Fingerposition führt.

Zudem offenbart die DE 10 2012 204 921 A1 eine Fahrzeugbedienvorrichtung welche durch eine mittels eines Fingers getätigte Gleitbewegung betätigbar ist, wobei mit einer zu geringen Kraft getätigte Eingaben ignoriert werden.

Die WO 2014/143200 A1 offenbart eine Verfahren zur Bestimmung eines Kontaktes von nicht leitfähigen Objekten mit einem berührungsempfindlichen kapazitiven Bedienelement. Aus zum gleichen Zeitpunkt erfassten Sensorsignalen wird ein Signalgefälle ermittelt, wobei in Abhängigkeit des Sensorgefälles in Bezug zu einem Vorgabewert die Sensorsignale verwertet oder verworfen werden.

Aus der US 2014/160060 A1 ein Verfahren zur Auswertung von Sensorsignalen eines berührungsempfindlichen kapazitiven Bedienelementes bekannt, wobei aus zu einem Zeitpunkt erfassten Werte eine Differenz zwischen einem maximalen erfassten Wert und einem minimalen erfassten Wert ermittelt wird. Aus der Differenz und einem Vorgabewert wird ein Vergleichswert ermittelt und sofern die Differenz größer als der Vergleichswert ist, wird ein weiterer Verfahrensschritt ausgeführt.

Mit dem Aufsetzen des Fingers kann also durch das Aufsetzen einerseits und das anschließende Verkippen oder Abrollen des Fingers vor der eigentlichen gewollten Bedienung andererseits bereits eine Bedienung erreicht werden, beispielsweise eine ungewollte Bewegung der Fingerposition in die eine Richtung, obwohl an sich eine Bewegung in die andere Richtung gewollt war. Dies führt in der Praxis, vor allem bei den angesprochenen eher kleinen Touchpads mit beispielsweise einer Reihe von kapazitiven Sensoren, dann häufig zu einer ungewollten Steuerung, in dem z.B. die Lautstärke, welche beispielsweise reduziert werden soll, mit dem Aufsetzen und Verkippen oder Abrollen des Fingers zuerst einmal lauter wird, bevor sie durch die Fingerbewegung reduziert wird. Neben diesem einfachen Beispiel sind auch andere Steuerungen in der Praxis wenig komfortabel, wenn sie beim Aufsetzen des Fingers bereits Steuerungsvorgänge auslösen, welche dann insbesondere auch noch entgegen der eigentlich gewünschten und angedachten Steuerung verlaufen.

Die Aufgabe der hier vorliegenden Erfindung besteht nun darin, ein verbessertes Verfahren zur Signalauswertung im Sinne des Oberbegriffs des Anspruchs 1 zu schaffen, welches den genannten Nachteil vermeidet oder zumindest stark reduziert, um so eine komfortable und effiziente Steuerung von berührungsempfindlichen kapazitiven Bedienelementen zu schaffen. Außerdem ist es die Aufgabe der Erfindung ein für das Verfah-ren geeignetes berührungsempfindliches Bedienele-ment anzugeben.

Erfindungsgemäß wird diese Aufgabe durch ein Verfahren mit den Merkmalen des Anspruchs 1 gelöst. Die Lösung wird durch hiervon abhängige Unteransprüche vorteilhaft weitergebildet. Im Anspruch 10 wird ein berührungsempfindliches Bedienelement angegeben.

Der Lösung im Anspruch 1 liegt die erfinderische Lösung zugrunde, in dem ein Verfahren geschaffen wird, bei welchem eine aus den Sensorhüben berechnete Fingerposition einer Wischbewegung in bestimmten Fällen nicht ausgegeben bzw. verworfen wird, also nicht an eine mit dem Sensor verbundene Steuerung, beispielsweise eines Cursors auf einem Bildschirm, eines Lautstärkereglers oder dergleichen, ausgegeben wird. Dies ist immer dann der Fall, wenn eine großflächige Abdeckung des gesamten Bedienelements, also mehrerer benachbarter Sensoren, identifiziert wird, sodass beispielsweise eine Differenz zwischen dem maximalen Sensorhub eines der Sensoren und dem minimalen Sensorhub eines der Sensoren zum gleichen Zeitpunkt kleiner als ein Vorgabewert ist. Unter dem Sensorhub wird vorliegend die Höhe eines von dem Sensor ausgegebenen Signals, beispielsweise eine Spannung, eine Kapazität oder ggfs. eine Frequenz verstanden, die zur Weiterverarbeitung in einem Steuergerät vorzugsweise in einen mehrere Zustände wiedergebenden digitalen Wert umgewandelt wird.

Ferner wird, wenn die Differenz zwischen dem maximalen und minimalen Sensorhub der Sensoren größer als der erste Vorgabewert ist, die Fingerposition nur ausgegeben falls der Sensorhub eines der erfassten Fingerposition am Rand des berührungsempfindlichen kapazitiven Bedienelements am nächsten gelegenen Sensors kleiner als ein zweiter Vorgabewert ist. Das durch eine Fingerberührung bewirkte Sensorsignal des oder der am Rand des Sensorfeldes gelegenen zur erfassten Fingerposition nächstgelegenen Sensoren werden mit dem zweiten Vorgabewert verglichen. Mit am Rand, d.h.

am äußeren Rand gelegen sind die Sensoren bezeichnet, die zumindest in einer Richtung, vorzugsweise in Bewegungsrichtung des Bedienfingers, das Sensorfeld beranden. Mit anderen Worten wird der Sensorhub des Sensor $H_{upper}$ einer erfassten Fingerposition mit dem zweiten Vorgabewet verglichen, der das Sensorfeld in Bewegungsrichtung des Bedienfingers berandet.

Es wird hier also ein zweiter Vorgabewert eingeführt, welcher dann den ersten Vorgabewert ergänzt. Durch Vergleich mit dem zweiten Vorgabewert wird sichergestellt, dass eine detektierte, gegenüber einer vorab bestimmten veränderten Fingerposition vorzugsweise in einer vorgegebenen Bewegungsrichtung auf dem Bedienelement tatsächlich durch eine gezielte Wischbewegung mit einer entsprechenden Fingerstellung und nicht durch ein Abrollen des Fingers bewirkt ist.

Durch das Unterrücken der Ausgabe der Fingerposition in diesen Varianten kann so eine initiale Fehlbedienung oder zumindest eine initiale potenzielle Fehlbedienung abgefedert werden, sodass bei dem berührungsempfindlichen kapazitiven Bedienelement möglichst nur genau die Eingaben umgesetzt und an eine nachfolgende Steuerung weitergegeben werden, welche so auch durch den Nutzer beabsichtigt waren. Potenzielle Fehleingaben beim Aufsetzen des Fingers sowie bei einem danach häufig erfolgenden Abrollen oder Verkippen des Fingers, was insbesondere bei berührungsempfindlichen Bedienelementen im Bereich eines Lenkrads häufig der Fall ist, werden so quasi herausgefiltert.

Dabei kann gemäß einer vorteilhaften Weiterbildung des erfindungsgemäßen Verfahrens vorzugsweise eine proportionale Abhängigkeit realisiert werden, sodass die zulässige Differenz zwischen dem maximalen und dem minimalen Sensorhub der Sensoren, ab welcher keine Ausgabe erfolgt, umso kleiner ist, je kleiner der erste Vorgabewert ist.

Gemäß einer weiteren sehr günstigen Ausgestaltung kann der Vorgabewert dabei von dem minimalen Sensorhub und/oder einer Fehlertoleranz der Sensoren abhängen. Er kann in einer einfachen Variante direkt von dem minimalen Sensorhub gebildet werden oder kann vorzugsweise durch den minimalen Sensorhub gebildet werden, wobei entweder der minimale Sensorhub oder die Differenz zwischen dem maximalen und dem minimalen Sensorhub der Sensoren mit einem entsprechenden Faktor multipliziert werden. Dieser Faktor kann beispielsweise ein sich aus der eingesetzten Hardware jeweils ergebender Faktor sein, welcher beispielsweise mit dem minimalen Sensorhub oder der Differenz multipliziert wird.

Die beiden Lösungsvarianten, also die Verwendung des minimalen Sensorhubs und/oder der Fehlertoleranz der Sensoren als ersten Vorgabewert, können dabei auch miteinander kombiniert genutzt werden, um so beide Bedingungen in der einen oder der anderen Reihenfolge der Prüfung oder durch eine parallele Prüfung und eine anschließende Und-Verknüpfung oder bevorzugt eine anschließende Oder-Verknüpfung entsprechend zu verbinden und auf dieser Basis über die Ausgabe der ermittelten Fingerposition zu entscheiden, diese also entweder zu verwerfen oder für die Eingabe entsprechend zu nutzen. In zwei Schritten wird beispielsweise überprüft, ob die Differenz ($\Delta$(min, max)) zwischen dem maximalen und minimalen Sensorhub (Hmax,Hmin) der Sensoren (3a, 3b, 3c, 3d) größer als der erste Vorgabewert ist, wobei der erste Vorgabewert bei einer ersten Überprüfung vom minimalen Sensorhub (Hmin) und bei einer zweiten Überprüfung von der Fehlertoleranz einer der Sensoren (3a, 3b, 3c, 3d) abhängig ist. Sofern soweit erforderlich der Sensorhub ($H_{upper}$) kleiner dem berechneten Vorgabewert ist, die berechnete Fingerposition (5) ausgegeben wird, wenn sowohl die erste Überprüfung und die zweite Überprüfung erfüllt sind; oder wenn zumindest eine der ersten oder zweiten Überprüfung erfüllt ist.

Die ergänzende oder alternative Variante, bei welcher die Fingerposition nur ausgegeben wird, wenn die Differenz zwischen dem maximalen und dem minimalen Sensorhub der Sensoren größer der Fehlertoleranz der oder zumindest einer der Sensoren ist, führt letztlich als Alternative oder ergänzende Lösung zu einem ähnlichen Ergebnis, weil auch hier faktisch ein Art Vorgabewert generiert wird, welcher in der Fehlertoleranz der einzelnen Sensoren besteht, und so vergleichbar wie bei der anderen Lösung dazu führt, dass zu kleine und sich insbesondere über zu viele Sensoren verteilende Sensorhübe quasi als Vollabdeckung oder flächige Abdeckung der Sensoren interpretiert werden und dementsprechend nicht zu einer Ausgabe der ermittelten Fingerposition führen.

Dabei kann es gemäß einer außerordentlich günstigen Weiterbildung des erfindungsgemäßen Verfahrens vorgesehen sein, dass der zweite Vorgabewert vom maximalen Sensorhub abhängig ist, wobei auch hier wieder insbesondere ein hardwareabhängiger Faktor auf der einen oder auf der anderen Seite einer der Bedingung zugrundeliegenden Gleichung angewandt werden kann.

Insbesondere am Beispiel des bereits angesprochenen Volumensliders in einem Fahrzeug-Lenkrad wird deutlich, dass bei einer weitgehend vollständigen Abdeckung des Sensors durch den Finger immense Schwankungen der jeweils berechneten Fingerposition zwischen den einzelnen Sensoren und der ihr zugeordneten Position auftreten können. In der Praxis zeigt sich, dass diese Schwankungen als hochfrequente Oszillationen des Ausgabesignals auf den entsprechenden Datenbussen des Fahrzeugs messbar sind. Um das Ergebnis nun nicht von diesem abhängig zu machen und insbesondere beispielsweise bei der Steuerung eines Cursors ein schnelles und als unkontrolliert wirkendes "Zucken" des Cursors zu vermeiden, kann es gemäß einer weiteren sehr vorteilhaften Ausgestaltung des erfindungsgemäßen Verfahrens auch vorgesehen sein, dass alle Änderungen der Fingerpositionen, welche auf einer über einer definierten maximalen Bewegungsgeschwindigkeit liegenden erfassten Fingergeschwindigkeit basieren, nicht ausgegeben werden. Zu schnelle Bewegungen bzw. hochfrequente Oszillationen der erfassten Fingerbewegungen können also verworfen werden, weil sie für die tatsächliche Steuerung quasi keine Rolle spielen und so gut wie immer mit einer Fehlinterpretation der eigentlich gewollten Steuerung einhergehen.

Die maximale Bewegungsgeschwindigkeit hängt dabei individuell von der jeweiligen das Bedienelement bedienenden Person und ihrer Art, den Finger aufzusetzen, ab. Außerdem spielen die ergonomischen Bedingungen in der Umgebung des Bedienelements eine Rolle. So wird beispielsweise bei einem Lenkrad die Steuerung häufig über den Daumen vorgenommen. Dann spielt die Position der Hand auf dem Lenkrad, die Größe der Hand und der dergleichen eine entscheidende Rolle. Es bietet sich daher an, und so ist es gemäß einer außerordentlich günstigen Weiterbildung des erfindungsgemäßen Verfahrens auch vorgesehen, dass die maximale Bewegungsgeschwindigkeit basierend auf einem globalen Startwert selbstlernend nutzerindividuell angepasst wird. Bei der Auslieferung hat das Bedienelement bzw. seine Steuerung einen globalen Startwert, welcher beispielsweise auf ermittelten Durchschnittswerten basiert. Mit der Zeit lernt das System dann, welche nutzerindividuellen hochfrequenten Oszillationen es feststellt, wenn der Nutzer das Bedienelement entsprechend bedient. Aus diesen erfassten Werten lässt sich dann selbstlernend ein individuelles Profil des Nutzers feststellen, sodass das System sich an den entsprechenden Nutzer anpasst und von im üblicherweise getätigte Abrollbewegungen oder Verkippbewegungen seines Fingers als solche erkennt und ergänzend zu den beiden erfindungsgemäßen Verfahren auch über eine Geschwindigkeitsbetrachtung zumindest teilweise ausfiltert.

In einer vorteilhaften weiteren oder alternativen Ausführungsform wird, wenn die Differenz ($\Delta$(min, max)) zwischen dem maximalen und minimalen Sensorhub ($H_{max}$, $H_{min}$) der Sensoren von zwei aufeinanderfolgenden Fingerpositionen jeweils größer als der erste Vorgabewert ist der Vergleich des Sensorhubs ($H_{upper}$) mit dem zweiten Vorgabewert für die letztere der zwei Fingerposition entfällt und die Ausgabe dieser Fingerposition erfolgt. Selbst wenn der Sensorhub ($H_{upper}$) eines der erfassten Fingerposition am nächsten gelegenen Sensors am Rand des berührungsempfindlichen kapazitiven Bedienelements größer als der zweite Vorgabewert ist, wird in diesem Fall dessen ungeachtet die Fingerposition ausgegeben. Vorzugsweise entfällt dieser Vergleich nur in einer vordefinierten Bewegungsrichtung. Bei einem am Lenkrad angeordneten Bedienelement beispielweise zur Einstellung der Lautstärke wird der Vergleich von ($H_{upper}$) mit dem zweiten Vorgabewert bei einer ersten Bewegung von oben nach unten berücksichtigt und bei einer weiteren Bewegung von unten nach oben nicht. Hintergrund dieser Unterscheidung ist, dass bei der ersten Bewegung durch ein Abrollen ein fehlerhaft, der Absicht des Bedieners nicht entsprechenden Fingerpositon bestimmt werden würde, bei der zweiten Bewegung die bestimmte Fingerposition aber eben genau der Absicht des Bedieners entspricht.

Zwar ließe sich ausschließlich die Richtung der erkannten Fingerbewegung vorzugsweise nach unten berücksichtigen, um potenzielle, durch Abrollen bewirkte Fehleingaben in die vermeintlich falsche Richtung abzufedern, sobald die übergeordnete richtige Richtung der Fingerbewegung einmal zutreffend erkannt worden ist. Wenn ein Nutzer sich jedoch während einer Eingabe in die eine Richtung dafür entscheidet die Eingaberichtung umzukehren und doch die Eingabe in die andere, entgegengesetzte Richtung fortzusetzen, würde dies zu unvermeidbaren Fehlern führen.

Somit lässt sich eine Hysterese definieren, um so klar zu erkennen, wann sensorisch vergleichbare oder identische Daten entweder verworfen werden, weil sie noch aus einer durch das Abrollen oder Verkippen des Fingers herrührenden Fehlinterpretation stammen, oder wann die Daten ausgegeben werden, weil sie vermeintlich von einer bewussten Bewegung sowie ggf. damit erzielten Änderung der Bewegungsrichtung durch den Nutzer herrührten.

Das erfindungsgemäße Verfahren in allen seinen beschriebenen Ausführungsvarianten und Kombinationen dieser Ausführungsvarianten lässt sich prinzipiell bei jeder Art von berührungsempfindlichen Bedienelementen entsprechend einsetzen. Besonders bevorzugt ist es jedoch so, dass das berührungsempfindlich Bedienelement zur Durchführung eines solchen Verfahrens mit einer Recheneinheit und mit mehreren in einer Reihe angeordneten kapazitiven Sensoren versehen ist. Im bestimmungsgemäßen Einsatz können diese vorzugsweise in einer Bewegungsrichtung von unten nach oben und umgekehrt bedienbar sein. Das erfindungsgemäße Verfahren lässt sich also vorzugsweise für ein solches Touchpad einsetzen, welches beispielsweise als Volumenslider verwendet werden kann, vorzugsweise im Lenkrad eines Fahrzeugs.

Vorteilhafte Ausgestaltungen des erfindungsgemäßen Verfahrens ergeben sich auch aus dem Ausführungsbeispiel, welches nachfolgend unter Bezugnahme auf die Figuren näher dargestellt ist.

Dabei zeigen:

Fig. 1 eine schematische Darstellung eines Bedienelements in Form eines Volumensliders;

Fig. 2 eine schematische Darstellung von an Sensoren gemessenen Sensorhüben während einer ergonomisch bedingten Abrollbewegung eines Fingers auf dem Bedienelement;

Fig. 3 eine schematische Darstellung einer Bewegung eines Fingers durch Abknicken des Daumenendgelenks auf einem Bedienelement;

Fig. 4 eine schematische Darstellung einer Bewegung durch Strecken des Daumenendgelenks auf dem Bedienelement;

Fig. 5 schematische Darstellung zur Erläuterung einer ersten Variante des erfindungsgemäßen Verfahrens anhand einer Darstellung analog zu der in Fig. 1;

Fig. 6 eine tabellarische Darstellung als Ergänzung zur grafischen Darstellung des Ablaufs in Fig. 5;

Fig. 7 eine tabellarische Darstellung für die Fälle gemäß Fig. 3 und Fig. 4; und

Fig. 8 eine alternative Ausführungsvariante des erfindungsgemäßen Verfahrens anhand des Ablaufs gemäß der Darstellung in Fig. 2.

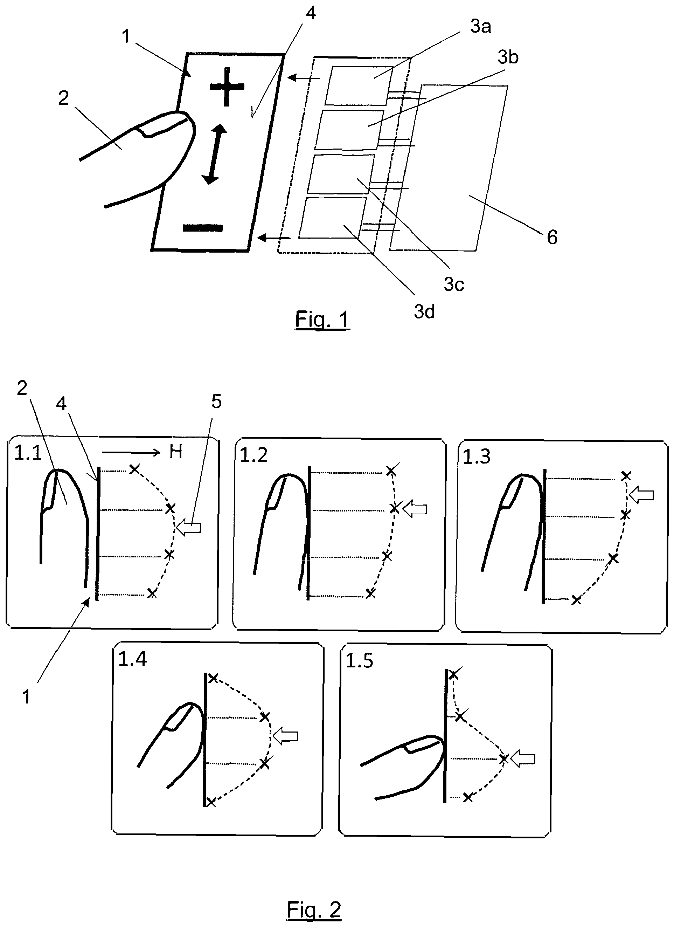

Kapazitive Bedienelemente 1 sind als Eingabegeräte für Mensch-Maschine-Schnittstellen allgegenwärtig und werden typischerweise als Touchscreen oder Touchpad bezeichnet und durch einen Finger 2 bedient. Die Erkennung der Fingerposition 5 (vgl. Figur 2) beruht dabei typischerweise auf der Annahme, dass die tatsächliche Fingerposition 5 aus den Sensorrohdaten berechnet wird, beispielsweise über eine Schwerpunktbildung, wie es im eingangs genannten Stand der Technik beschrieben ist. Dies bedeutet insbesondere, dass sich die Kontaktfläche zwischen dem Finger 2 und einer Sensoroberfläche 4 des Bedienelements 1 während einer laufenden Bedienung nicht oder allenfalls symmetrisch, beispielsweise durch eine senkrechte Annäherung der Fingerspitze an das Bedienelement 1, verändert. In realen Situationen ist diese Annahme allerdings selten erfüllt, insbesondere nicht dann, wenn das Bedienelement 1 ergonomisch ungünstig positioniert ist, beispielsweise in einem Lenkrad, sodass die Bedienung nicht von senkrecht oben erfolgt, sondern beispielsweise mittels eines Daumens, welcher von einer den Lenkkranz des Lenkrads greifenden Hand in Richtung des Bedienelements 1 gestreckt wird, um dieses entsprechend zu bedienen. Ohne eine Einschränkung auf ein solches Bedienelement 1 soll das nachfolgende Ausführungsbeispiel nun anhand eines Volumensliders in einem Lenkrad beschrieben werden, welcher vertikal orientiert ist und beispielsweise zur Veränderung der Lautstärke der Audioausgabe eines Telematiksystems dient. In der Darstellung der Figur 1 ist ein solcher Volumenslider als Bedienelement 1 schematisch angedeutet. Die Anordnung im Lenkrad führt typischerweise dazu, dass der Nutzer seine hier mit 2 bezeichnete Fingerspitze in der Regel nicht wie bei Bildschirmen senkrecht über die Oberfläche des Bedienelements 1 führt, sondern das Bedienelement 1 mit schräg anliegendem Finger 2 bedient.

Ein übliches und durchaus problematisches Bedienmuster ist dabei eine Abrollbewegung der Fingerkuppe, die das Bedienelement 1 bzw. seine unter der Oberfläche 4 liegenden hier mit 3a, 3b, 3c, 3d bezeichneten kapazitiven Sensoren so stimuliert, dass die in einer Recheneinheit 6 berechnete Bewegung des Fingers 2 der tatsächlichen Bewegung entgegengesetzt ist. Dies soll nachfolgend am Beispiel einer solchen Bewegung in der Darstellung der Figur 2 beschrieben werden. In der Figur 2 ist dazu die Oberfläche 4 des Bedienelements 1 zusammen mit dem Finger 2 entsprechend dargestellt.

In der Darstellung rechts neben der Bedienfläche sind über das x jeweils die Sensorhübe H der einzelnen kapazitiven Sensoren 3a bis 3d angedeutet. Die gestrichelte Linie stellt eine dazwischen interpolierte oder nach anderen mathematischen Verfahren berechneten Ausschlag der Sensoren 3a bis 3d qualitativ dar. Der jeweils mit 5 bezeichnete Pfeil symbolisiert die erfasste Fingerposition.

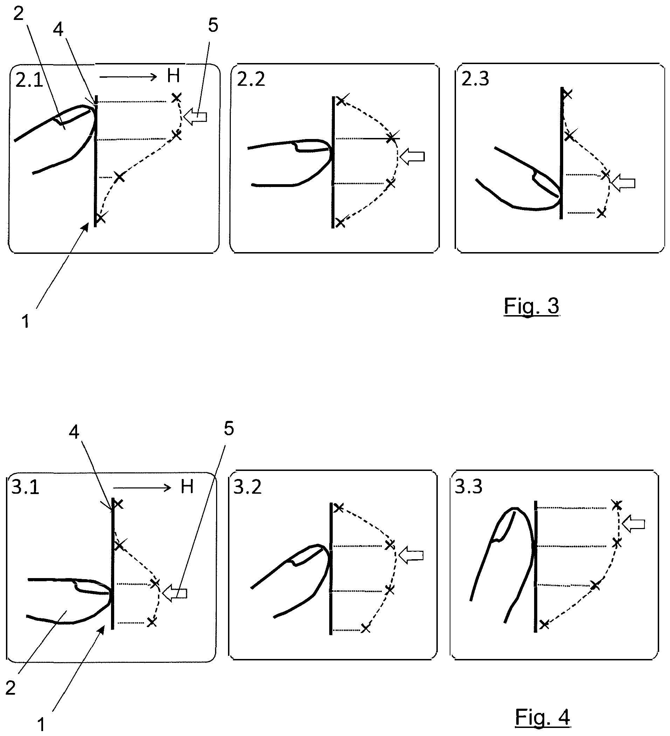

In der Darstellung der Figur 2 sind dabei fünf im zeitlichen Ablauf nacheinander folgende Abbildungen mit jeweils verschiedenen sich im jeweiligen Bedienschritt 1.1 bis 1.5 ergebenden Positionen des Fingers 2 dargestellt. Die jeweiligen Bezugszeichen sind dabei jeweils nur im ersten Bedienschritt 1.1 eingezeichnet und ergeben sich für die folgenden Schritte 1.2 bis 1.5 analog. Dies gilt auch für die nachfolgenden Figuren 3, 4, 5 und 8.

Die gewünschte Bewegung des Fingers 2 soll eine Abwärtsbewegung, also beispielsweise zum Verringern der Lautstärke, sein. Im ersten Bedienschritt 1.1 der Figur 2 setzt der Nutzer den durchgestreckten Finger 2, hier den Daumen, nahezu parallel zur Sensoroberfläche 4 auf. Dies geschieht üblicherweise wenn der Nutzer den Lenkradkranz, wie es bei der Fahrt üblich ist, mit den übrigen Fingern der Hand umgreift. Dieses gleichmäßige Aufsetzen führt dazu, dass alle einzelnen Sensoren 3a bis 3d nahezu vollständig abgedeckt werden. Je nach Fingerform bleibt am oberen oder unteren Ende des Bedienelements 1 gegebenenfalls noch ein geringer Abstand zwischen dem Finger 2 und der Sensoroberfläche 4 bestehen. In diesem Fall ist der Sensorhub H in der Mitte des Bedienelements 1 am höchsten und eine Berechnung des Fingerschwerpunkts kann hier noch einigermaßen zuverlässig erfolgen und wird, wie es durch den die berechnete Fingerposition 5 anzeigenden Pfeil angedeutet ist, in etwa in der Mitte des Bedienelements 1 verortet.

In der Folge, und dies ist im Bedienschritt 1.2 dargestellt, zieht der Nutzer den Finger 2 nach unten. Er behält aber gleichzeitig die Hand am Lenkradkranz, sodass die Mechanik seiner Hand bedingt, dass sich die Achse des Fingers 2, hier des Daumens, verschiebt und dieser auf der Sensoroberfläche 4 entsprechend abrollt. Dabei vergrößert sich der Sensorhub H im Bereich des oberen am Rand des Sensors 1 liegenden Einzelsensors 3a, während er sich am unteren Einzelsensor 3d tendenziell verringert. Die berechnete Fingerposition 5 verschiebt sich damit entgegen der eigentlich angedachten Bewegung des Fingers 2 nach oben. Dabei ist zu beachten, dass trotz der qualitativ unterschiedlichen Sensorhübe H in diesem Schritt die Sensoroberfläche 4 des Bedienelements 1 im Wesentlichen noch vollständig abgedeckt ist und deshalb in jedem der Einzelsensoren 3a bis 3d noch einen nennenswerten Ausschlag bzw. Sensorhub H liefert.

Im nachfolgend dargestellten Bedienschritt 1.3, welcher als Fortführung der Bewegung im Bedienschritt 1.2 zu verstehen ist, verschiebt sich der berechnete Schwerpunkt der Fingerposition 5 noch weiter nach oben mit dem einzigen Unterschied, dass der Sensorhub des unteren Einzelsensors 3d sehr deutlich zu sinken beginnt.

In dem zeitlich nachfolgenden Bedienschritt 1.4 verschiebt sich die Achse des Finger 2 weiter und gleichzeitig beginnt eine Fingerspitze des Fingers 2, hier also des Daumens, deutlich nach unten zu wandern, was die durch den Nutzer angedachte Bewegungsrichtung ist. Der Sensorhub H des obersten Einzelsensors 3a beginnt entsprechend zu sinken und die berechnete Fingerposition 5 nähert sich wieder der tatsächlichen Fingerposition an. Im abschließenden Bedienschritt 1.5 der Figur 2 steht die Fingerachse nun steil genug auf der Sensoroberfläche 4, sodass die Fingerposition 5 hier zuverlässig berechnet werden kann. Das Problem liegt nun darin, dass der Nutzer also glaubt, dass er während der gesamten Eingabe seinen Finger 2 von oben nach unten bewegt hat und folglich auch eine entsprechende Systemreaktion, also beispielsweise eine Verringerung der Lautstärke, erwartet. Reagiert nun das System stattdessen während der Schritte 1 2 und 1.3 mit einer dem gewünschten Verhalten genau entgegengesetzten Reaktion, so ist dies entsprechend irritierend und wird als Fehlfunktion bzw. wenig komfortable Eingabe durch den Nutzer interpretiert.

Kommt es dahingegen zu einer weitgehend idealtypischen Nutzereingabe durch ein Abknicken des Daumenendgelenks, ergeben sich bei einer Bewegung nach unten die in der Darstellung der Figur 3 gezeigten Bedienschritten 2.1 bis 2.3 zeitlich aufeinanderfolgend. Im Bedienschritt 2.1 der Figur 3 hat der Nutzer seine Eingabe am oberen Rand des Bedienelements 1 bzw. der Sensoroberfläche 4 gestartet, der Schritt 2.1. zeigt im Gegensatz zu 1,1, nicht das erste Aufsetzen sondern bereits eine Bewegung. Dabei greift er das Lenkrad bestenfalls locker und hebt die Handwurzel weit genug aus der Lenkradebene heraus, sodass die Spitze seines Fingers 2, hier also die Daumenspitze, allein durch das Knicken des Daumenendgelenks über die Sensoroberfläche 4 bewegt werden kann. Die Einzelsensoren 3a bis 3d messen in diesem Bedienschritt einen entsprechend hohen Ausschlag bei den beiden oberen Sensoren 3a und 3b, während sie im Bereich der beiden unteren Sensoren 3c und 3d Werte im Bereich des Hintergrundrauschens liefern. Die Fingerposition 5 lässt sich dadurch eindeutig auf den oberen Bereich festlegen. Die Fortführung der Bewegung nach unten gemäß den Bedienschritten 2.2 und 2.3 erfolgt dann durch Knicken des Daumenendgelenks, sodass der Finger 2 während der kompletten Bewegung jeweils nur einen kleinen Teil der Sensoroberfläche 4 abdeckt und sich die Fingerposition 5 dadurch zuverlässig berechnen lässt.

In der Darstellung der Figur 4 sind anhand der Bedienschritte 3.1 bis 3.3 dieselben Bewegungsschritte einer solchen idealtypischen Nutzereingabe für eine Bewegung nach oben, also beispielsweise eine Steigerung der Lautstärke in dem oben genannten Beispiel, beschrieben. In den Bedienschritten 3.1 und 3.2 erfolgt eine Nutzereingabe nach einem vorgelagerten, nicht gezeigten Fingeraufsetzten nach oben durch Strecken des Daumengelenks, sodass der Finger 2 zuerst die unteren Sensoren 3d und 3c, dann die mittleren Sensoren 3d und 3c und abschließend die oberen Sensoren 3a und 3b entsprechend anspricht und die gesamte erfasste Bewegung der Fingerposition 5 hier in der gewünschten Bewegungsrichtung, also von unten nach oben, verläuft.

Nun muss für eine Steigerung der Bedienfreundlichkeit des Bedienelements 1 primär die anhand der Figur 2 und der dortigen Bedienschritten 1.1 bis 1.5 erläuterte Fehleingabe unterdrückt werden, während die Eingaben gemäß der Figuren 3 und 4 nicht unterdrückt werden sollen. Insbesondere fällt dabei auf, dass die Abbildung des Bedienschritts 1.3 und die des Bedienschritts 3.3. sich entsprechen. Dennoch ist es wichtig, in einen Fall der Figur 2 die Eingabe der ungewollten Bewegungsrichtung nach oben herauszufiltern und im anderen in Figur 4 dargestellten Fall die hinsichtlich der erfassten Hübe H der Sensoren 3a bis 3d identische Situation eben nicht herauszufiltern.

Als wesentlicher Aspekt für die fehlerhafte Erkennung der Fingerposition 5 lässt sich dabei in Figur 2 vor allem die nahezu vollflächige Abdeckung des Bedienelements 1 bzw. seiner Sensoren 3a bis 3d erfassen. Ein zentraler Ansatz, um die unerfreuliche Reaktion des Bedienelements 1 auf eine solche Bedienung zu korrigieren, sieht es also vor, dass die Berechnung der Fingerposition 5 bzw. ihre Weitergabe an eine durch das Bedienelement 1 gesteuerte Einrichtung ausgesetzt wird, wenn eine solche nahezu vollflächige Abdeckung der Sensoroberfläche 4 erkannt wird. Eine solche vollflächige Abdeckung der Sensoroberfläche 4 liegt dabei typischerweise immer vor, wenn der kleinste Sensorhub H eines der Sensoren 3a bis 3d größer ist als die Differenz zwischen dem größten und dem kleinsten Sensorhub H der Sensoren 3a bis 3d. Die Differenz $\Delta$(min, max) muss also kleiner als ein Vorgabewert sein, welcher vorzugsweise durch den kleinsten Sensorhub $H_{min}$, insbesondere zusammen mit einem Skalierungsfaktor $f_1$, gebildet wird. Dieser erste Vorgabewert wäre in dem dargestellten Ausführungsbeispiel also der minimale Sensorhub $H_{min}/f_1$ oder, um auf den Skalierungsfaktor $f_1$ im Nenner verzichten zu können,

$$H_{min} > f_1 * \Delta(min,\ max) \qquad (I).$$

Der Skalierungsfaktor $f_1$ ist dabei im Wesentlichen von der Hardware des Bedienelements 1 abhängig und lässt sich beispielsweise im Rahmen der Implementierung des Verfahrens auf einem konkreten konstruktiven Aufbau entsprechend festlegen, sodass hier keine Beispiele angegeben werden sollen.

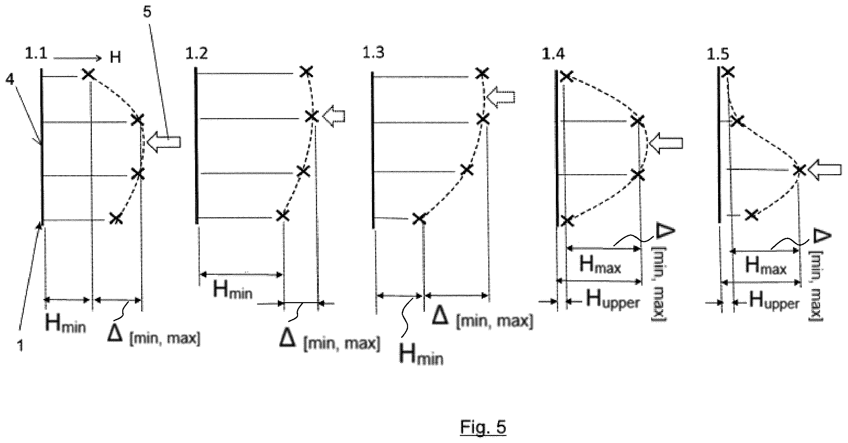

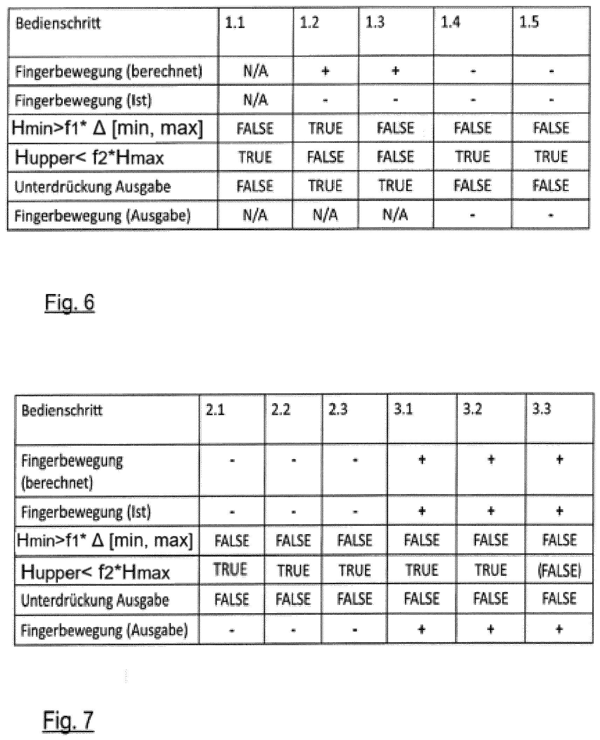

Die Lösung lässt sich mit minimalem Rechenaufwand realisieren, insbesondere wenn die Abfrage lediglich in der Art erfolgt, dass die Bedingung ausgedrückt als Boolescher Wert von Falsch auf Wahr wechselt oder umgekehrt. Mit dieser Bedingung ist dann eine Regel definiert, nach der die in den Bedienschritten 1.1 und 1.2 der Figur 2 fehlerhaft erkannte Ausgabe der Fingerposition 5 unterdrückt werden kann. In der Darstellung der Figur 5 ist dies mit den eingezeichneten Werte $H_{min}$ und $\Delta(min, max)$ nochmals entsprechend dargestellt. In Figur 6 sind die Bedienschritte ebenfalls entsprechend der Nummerierung 1.1 bis 1.5 nochmals in den Spalten einer Tabelle aufgeführt. Die Richtung der durch Sensorauswertung berechneten Fingerbewegung, der tatsächlichen Fingerbewegung als auch die Richtung der ausgegebenen Fingerbewegung ist entsprechend Fig. 1 nach unten mit "-" und nach oben mit "+" bezeichnet. Eine Unterdrückung der Ausgabe der Fingerposition ist mit TRUE bezeichnet, eine Ausgabe der Fingerposition erfolgt demgemäß bei der Bezeichnung FALSE.

Im Schritt 1.1 wird aufgrund der Tatsache, dass es der erste erfasste Wert zum Zeitpunkt des Fingeraufsetzens ist, prinzipbedingt zwar eine Fingerposition, die auch ausgegeben wird, aber noch keine Fingerbewegung (N/A) bestimmt. Im Schritt 1.2 wird eine Fingerbewegung nach oben berechnet, was hier durch das + unter Bezugnahme auf den Volumenslider der Figur 1 entsprechend dargestellt ist, die tatsächliche vom Nutzer beabsichtige mit "Fingerbewegung ist" bezeichnete Fingerbewegung ist jedoch in die entgegengesetzte Richtung nach unten gerichtet, was hier wiederum durch das - dargestellt ist. In der dritten Zeile ist gemäß der obigen Formel die Bedingung $H_{min} > f_1 * \Delta(min, max)$ dargestellt, welche hier zwischen dem ersten Bedienschritt 1.1 und dem zweiten Bedienschritt 1.2 von Falsch (false) auf Wahr (true) wechselt. Das Flag true für $H_{min} > f_1 * \Delta(min, max)$ bedeutet, dass $\Delta(min, max)$ kleiner dem ersten Vorgabewert ist und die Bedingung für eine Ausgabe nicht erfüllt ist, das flag false für $H_{min} > f_1 * \Delta(min, max)$ bedeutet, dass die Bedingung für eine Ausgabe erfüllt ist. Dementsprechend wird, wie es in der vorletzten Zeile dargestellt ist, die Ausgaben unterdrückt, beim Bedienschritt 1.2 ist diese Unterdrückung der Ausgabe also wahr (true) und es erfolgt keine Ausgabe (N/A).

Wie oben bei der Erläuterung der Figur 2 beschrieben, ist auch der Schritt 1.3 noch mit einer fehlerhaften Bewegungsrichtung der Fingerbewegung behaftet, wie es durch das "+/-" in den ersten beiden Zeile der Tabelle in Figur 6 dargestellt ist, wodurch die unterschiedliche Richtungen der berechneten und der vom Nutzer beabsichtigen Fingerbewegung verdeutlicht sind.

Dadurch, dass der Sensorhub H des untersten Sensors 3d hier jedoch sehr gering ist, wird die erste Bedingung falsch, da die Differenz des minimalen und maximalen Sensorhubs $\Delta(min, max)$ dementsprechend größer als der minimale Sensorhub $H_{min}$ wird.

In der Praxis soll dieser Fall nun jedoch unterdrückt werden, weil die Bewegung auch hier noch nach oben gerichtet ist, wie es im Rahmen der Figur 2 erläutert worden ist. Eine naheliegende Lösung mag zunächst sein, bei einem Wechsel der ersten Bedingung auf Wahr die erfasste Fingerposition und zugehörige Bewegungsrichtung für alle zukünftigen Bedienschritte entsprechend zu verwerfen. Allerdings würde dies dazu führen, dass eine bewusste Umkehr der Bewegungsrichtung durch den Nutzer nicht erfasst werden würde, was ebenfalls den Komfort der Eingabe deutlich schmälert. Nun ist es jedoch so, dass bei dieser Konstellation zwischen dem Bedienschritt 1.3 und 1.4 die Spitze des Fingers 2 sich zunehmend von dem oberen Sensor 3a entfernt. Eine solche Entfernung von der der Spitze des Fingers 2 am nächsten liegenden Sensor 3a bis 3d, hier dem Sensor 3a, welcher am Rand des Bedienelements 1 angeordnet ist, zeigt also an, dass sich die Fingerposition 5 zuverlässig nach oben abgrenzen lässt. Ab diesem Zeitpunkt besteht dann keine Notwendigkeit mehr, die Fingerbewegung künstlich zu begrenzen, um den Nutzer so die Möglichkeit zu geben, die Fingerbewegung umzukehren, ohne dazwischen durch ein Abheben des Fingers das Bedienelement zurücksetzen zu müssen.

Als zweite Bedingung, welche nachfolgend zu der oben genannten ersten Bedingung $H_{min} > f_1 * \Delta(min, max)$ zu prüfen wäre, ergibt sich somit eine Überprüfung, ob der Sensorhub $H_{upper}$ des obersten Sensors 3a kleiner als der höchste gemessene Sensorhub $H_{max}$ ist. Auch hier kann wieder ein Skalierungsfaktor $f_2$ eine Rolle spielen, welcher ähnlich wie der erste Skalierungsfaktor $f_1$ beispielsweise während der Implementierung ermittelt werden kann. Die Formel für die zweite Bedingung lautet dann

$$H_{upper} < f_2 * H_{max} \qquad (II).$$

Das Flag true bedeutet, dass der Sensorhub ($H_{upper}$) eines der erfassten Fingerposition am nächsten gelegenen Sensors (3a) am Rand des berührungsempfindlichen kapazitiven Bedienelements (1) kleiner dem zweiten Vorgabewert ist und die Bedingung erfüllt ist. Mit diesen beiden Bedingungen I und II lässt sich nun einen Ablauf wie folgt definieren: Die Eingabe startet, die erste Bedingung I ist falsch und es erfolgt eine reguläre Ausgabe der Fingerpositionsberechnung, was in der Darstellung der Figuren 5 und 6 dem Bedienschritt 1.1 entspricht. Im Anschluss wechselt die Bedingung I von Falsch auf Wahr und die Ausgabe beim Bedienschritt 1.2 wird entsprechend unterdrückt, da ein Wahr der Bedingung 1 eine Unterdrückung der Ausgabe bewirkt. Im dritten Bedienschritt wechselt die Bedingung I wiederum zu Falsch und die Bedingung II ist ebenfalls falsch, sodass die Ausgabe zwar nicht wegen der Bedingung I aber wegen der Bedingung II weiterhin unterdrückt wird, da ein False der Bedingung 1 die Ausgabe unterdrückt. Erst im nachfolgenden Schritt wird dann bei falscher erster Bedingung I die zweite Bedingung II wahr und es erfolgt eine reguläre Ausgabe, was dann für die Bedienschritte 1.4 und 1.5 aufrechterhalten wird. (False in Bedingung 1 und Wahr in Bedingung 2 führt zu einer durch False beschriebene regulären Ausgabe).

In der Tabelle der Figur 7 wird nun in einer analogen Darstellung das soeben beschriebene Verfahren auf die in den Figuren 3 und 4 gezeigten Bedienschritte 2.1 bis 2.3 bzw. 3.1 bis 3.3 entsprechend angewandt. Wie erwartet ergibt sich hier keine Unterdrückung der Ausgabe von Fingerposition und der Fingerbewegung, da wie bei der Beschreibung der Figuren 3 und 4 erwähnt, hier eine quasi idealtypische Nutzung des Bedienelements 1 vorliegt.

Der einzige Aspekt, welcher hier relativ schnell auffällt ist, ist der im letzten Bedienschritt 3.3 dargestellte Zustand. Dieser entspricht hinsichtlich der erfassten Sensorhübe H der Sensoren 3a bis 3d exakt dem im Bedienschritt 1.3 dargestellten Zustand. Bei 1.3 handelt es sich um eine Fehlinterpretation, welche durch die falsch werdende zweite Bedingung II bezüglich der Ausgabe unterdrückt wird. Eine solche Vorgehensweise wäre hier jedoch nicht zielführend, da die im Bedienschritt 3.3 ermittelte Fingerposition 5 genau die ist, welche vom Nutzer beabsichtig und gewollt ist. Der Unterschied, welcher sich hier aus dem oben beschriebenen Ablauf ergibt, liegt nun darin, dass zwischen den Bedienschritten 1.2 und 1.3 die erste Bedingung I von Wahr auf Falsch gewechselt hat, während die erste Bedingung I zwischen den Bedienschritten 3.2 und 3.3 eben aufgrund der anderen Bewegungsrichtung nicht gewechselt hat. Erfolgt also zwischen zwei Bedienschritten bzw. daraus ermittelten Fingerpositionen 5 insbesondere bei einer durch Berechnung anhand der Sensorsignale bestimmten Bewegungsrichtung nach oben "+" kein Wechsel in der ersten Bedingung I, dann kann in dem zweiten der Bedienschritte auf das Abprüfen der zweiten Bedingung gänzlich verzichtet werden, sodass auch im Falle eines Wechsels der zweiten Bedingung II $H_{upper} < f_2 * H_{max}$ von Wahr auf Falsch, wie es hier der Fall ist, dieser Wechsel eben nicht wie in der Tabelle der Figur 6 zu einer Unterdrückung der Ausgabe führt. Das false der zweiten Bedingung ist daher dort entsprechend eingeklammert dargestellt.

Alternativ wird die zweite Bedingung II nur bei einer berechneten Bewegungsrichtung, nämlich von oben nach unten "-" berücksichtigt und in der entgegengesetzten Richtung von unten nach oben "+" nicht betrachtet, so dass bei einer entsprechenden Umkehr der Bewegungsrichtung ein dem Nutzerwunsch entsprechende Ausgabe der Bewegungsrichtung erfolgt.

Weitere Verfeinerungen des Verfahrens sind ebenfalls möglich, um insbesondere auch in Grenzfällen genau dann die Weitergabe der Fingerposition 5 zu unterdrücken, wenn dies gewünscht ist und sie eben nicht zu blockieren, wenn es nicht gewünscht ist. Eine solche Verfeinerung kann beispielsweise auf der Überlegung basieren, dass bei einer Vollabdeckung der Sensoroberfläche 4 bereits minimale Änderungen der jeweiligen Sensorhübe H zu immensen Schwankungen der berechneten Fingerposition 5 führen können. In der Praxis führt dies dann zu einer hochfrequenten Oszillation des Ausgabesignals, also einer sehr starken erfassten Bewegungsgeschwindigkeit der Änderung der Fingerpositionen 5. Um das Problem zu beheben, lässt sich also ergänzend zu dem oben beschriebenen Verfahren eine zulässige Maximalgeschwindigkeit der Bewegung der Fingerposition 5 definieren, um so alle schnelleren Änderungen zu verwerfen. Da die Bedienmuster je nach Nutzer in der Art und Geschwindigkeit stark variieren, beispielsweise aufgrund der typischen Handhaltung am Lenkrad, der Größe der Hand und dergleichen, kann nicht ohne weiteres davon ausgegangen werden, dass ein einzelner festgelegter Wert für die Maximalgeschwindigkeit den besten Komfort garantiert. Deshalb kann für jeden Benutzer im Laufe der Zeit ein individueller Wert aufgrund der Bedienung des Bedienelements 1 selbstständig ermittelt, festgelegt und bei Bedarf abgepasst werden, welcher zu einem komfortablen und zuverlässigen Bedienen des Bedienelements 1 führt.

Die bisher vorgestellten Rechenschritte sind arithmetisch sehr simpel und können auch auf Systemen mit sehr begrenzter Rechenleistung, beispielsweise einer Steuerung bzw. der Recheneinheit 6 des Bedienelements 1 selbst, außerordentlich effizient durchgeführt werden.

Alternativ oder insbesondere ergänzend zu der Abfrage der Bedingung I ließe sich nun auch eine Verfeinerung über eine Fehlerbetrachtung des Systems realisieren, das in hinreichender Zeit eine quantitative Abschätzung des Fehlers liefern könnte, mit dem die berechnete Fingerposition 5 behaftet ist. Eine solche Einschätzung kann beispielsweise anhand der Gauß'schen Fehlerfortpflanzung erfolgen, womit sich ein simples zu der anderen Ausführung mit der Bedingung I komplementäres oder auch ergänzendes Verfahren definieren lässt, bei welchem die in einem definierten Zeitintervall T berechnete Fingerpositionsänderung $\Delta X(T)$ kleiner als das Fehlerintervall $\delta X$ der Fingerposition 5 ist, welche gegebenenfalls wieder mit einem entsprechenden hier ortsabhängigen Faktor $f_3(X)$ multipliziert werden kann. Die Formel würde dann lauten:

$$\Delta X(T) < \delta(X) * f_3(X) \qquad (III).$$

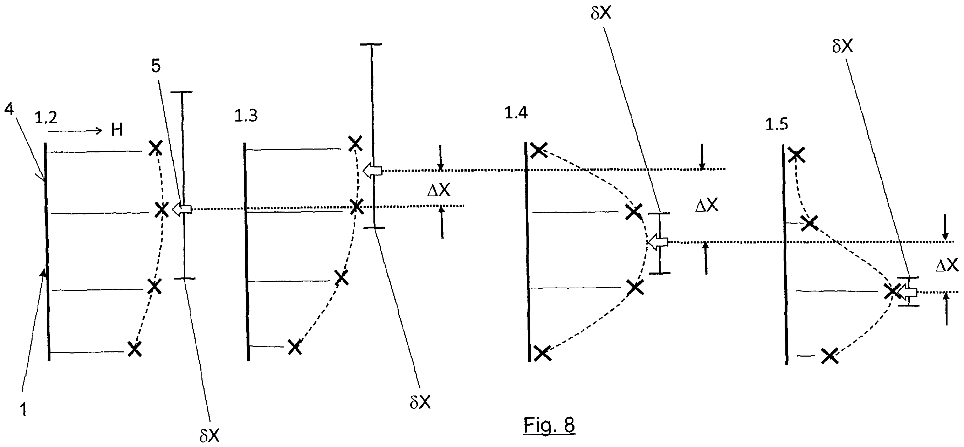

Ist diese Bedingung III erfüllt, wird die Ausgabe der Fingerposition 5 unterdrückt, sodass diese Abfrage, eine ausreichende Rechenleistung vorausgesetzt, an die Stelle der Überprüfung der Bedingung I oder auch ergänzend dieser Überprüfung der Bedingung I vor- oder nachgeschaltet ermittelt werden kann. In der Darstellung der Figur 8 sind nun die entsprechenden Werte nochmals in den Bedienschritten 1.2 bis 1.5 analog zu denen in der Darstellung der Figuren 2 und 5 entsprechend dargestellt.

**Patentansprüche**

1. Verfahren zur Signalauswertung von über einen Finger (2) getätigten Eingaben auf einem berührungsempfindlichen kapazitiven Bedienelement (1), umfassend wenigstens zwei kapazitive Sensoren (3a, 3b, 3c, 3d), wobei aus zum gleichen Zeitpunkt erfassten Sensorhüben (H) einzelner kapazitiver Sensoren (3a, 3b, 3c, 3d) eine Fingerposition (5) berechnet wird, wobei die berechnete Fingerposition (5) nicht ausgegeben wird, wenn eine Differenz ($\Delta$(min, max)) zwischen dem maximalen und minimalen Sensorhub ($H_{max}$,$H_{min}$) der Sensoren (3a, 3b, 3c, 3d) kleiner als ein Vorgabewert ist,
**dadurch gekennzeichnet, dass**

> die Fingerposition (5) ausgegeben wird
> wenn die Differenz ($\Delta$(min, max)) zwischen dem maximalen und minimalen Sensorhub ($H_{max}$,$H_{min}$) der Sensoren (3a, 3b, 3c, 3d) größer als der erste Vorgabewert ist und
> der Sensorhub ($H_{upper}$) eines der erfassten Fingerposition (5) am nächsten gelegenen Sensors (3a) am Rand des berührungsempfindlichen kapazitiven Bedienelements (1) kleiner als ein zweiter Vorgabewert ist.

**2.** Verfahren nach Anspruch 1,
**dadurch gekennzeichnet, dass**
die zulässige Differenz ($\Delta$(min, max)) zwischen dem maximalen und minimalen Sensorhub ($H_{max}$,$H_{min}$) der Sensoren (3a, 3b, 3c, 3d) ab welcher keine Ausgabe erfolgt umso kleiner ist, je kleiner der erste Vorgabewert ist.

**3.** Verfahren nach Anspruch 1 oder 2,
**dadurch gekennzeichnet, dass**
der erste Vorgabewert vom dem minimalen Sensorhub ($H_{min}$) abhängig ist.

**4.** Verfahren nach einem der Ansprüche 1 bis 3,
**dadurch gekennzeichnet, dass**
der erste Vorgabewert von einer Fehlertoleranz einer der Sensoren (3a, 3b, 3c, 3d) abhängig ist und die Fingerposition (5) nur ausgegeben wird, wenn eine Differenz ($\Delta$(min, max)) zwischen dem maximalen und minimalen Sensorhub ($H_{max}$,$H_{min}$) der Sensoren (3a, 3b, 3c, 3d) größer einer Fehlertoleranz einer der Sensoren (3a, 3b, 3c, 3d) ist.

**5.** Verfahren nach einem der Ansprüche 1 bis 4,
**dadurch gekennzeichnet, dass**
der zweite Vorgabewert vom maximalen Sensorhub ($H_{max}$) abhängig ist.

**6.** Verfahren nach einem der Ansprüche 1 bis 5,
**dadurch gekennzeichnet, dass**
alle Änderungen der Fingerpositionen (5), welche auf einer über einer definierten maximalen Bewegungsgeschwindigkeit liegenden erfassten Bewegungsgeschwindigkeit des Fingers (2) basieren, nicht ausgegeben werden.

**7.** Verfahren nach Anspruch 6,
**dadurch gekennzeichnet, dass**
die maximale Bewegungsgeschwindigkeit basierend auf einem globalen Startwert selbstlernend nutzerindividuell angepasst wird.

**8.** Verfahren nach einem der Ansprüche 1 bis 7,
**dadurch gekennzeichnet, dass**
wenn die Differenz ($\Delta$(min, max)) zwischen dem maximalen und minimalen Sensorhub ($H_{max}$,$H_{min}$) der Sensoren (3a, 3b, 3c, 3d) von zwei aufeinanderfolgenden Fingerpositionen (5) jeweils größer als der erste Vorgabewert ist der Vergleich des Sensorhubs ($H_{upper}$) mit dem zweiten Vorgabewert für die letztere Fingerposition entfällt und die Ausgabe erfolgt.

**9.** Verfahren nach Anspruch 8,
**dadurch gekennzeichnet, dass**
der Vergleich des Sensorhubs ($H_{upper}$) mit dem zweiten Vorgabewert nur in einer vordefinierten Bedienrichtung des Bedienelementes entfällt.

**10.** Berührungsempfindliches Bedienelement (1) zur Durchführung eines Verfahrens nach einem der Ansprüche 1 bis 9, mit einer Recheneinheit (6) und mit mehreren in einer Reihe angeordneten kapazitiven Sensoren (3a, 3b, 3c, 3d), welche im bestimmungsgemäßen Einsatz vorzugsweise in einer Bewegungsrichtung von oben nach unten und umgekehrt bedienbar sind.

**Claims**

**1.** Method for evaluating the signal of inputs made by a finger (2) on a touch-sensitive capacitive operating element (1) comprising at least two capacitive sensors (3a, 3b, 3c, 3d), a finger position (5) being calculated from sensor strokes (H) of individual capacitive sensors (3a, 3b, 3c, 3d) detected at the same time, the calculated finger position (5) not being output if a difference ($\Delta$(min, max)) between the maximum and minimum sensor stroke ($H_{max}$, $H_{min}$) of the sensors (3a, 3b, 3c, 3d) is smaller than a preset value,
**characterized in that**

> the finger position (5) is output
> if the difference ($\Delta$(min, max)) between the maximum and minimum sensor stroke ($H_{max}$, $H_{min}$) of the sensors (3a, 3b, 3c, 3d) is greater than the first preset value, and
> the sensor stroke ($H_{upper}$) of a sensor (3a) nearest the detected finger position (5) at the edge of the touch-sensitive capacitive operating element (1) is smaller than a second preset value.

**2.** Method according to claim 1,

**characterized in that**
the permissible difference ($\Delta$(min, max)) between the maximum and minimum sensor stroke ($H_{max}$, $H_{min}$) of the sensors (3a, 3b, 3c, 3d) from which there is no output is smaller, the smaller the first preset value is.

3. Method according to claim 1 or claim 2, **characterized in that** the first preset value is dependent on the minimum sensor stroke ($H_{min}$).

4. Method according to any of claims 1 to 3, **characterized in that** the first preset value is dependent on an error tolerance of one of the sensors (3a, 3b, 3c, 3d) and the finger position (5) is output only if a difference ($\Delta$(min, max)) between the maximum and minimum sensor stroke ($H_{max}$, $H_{min}$) of the sensors (3a, 3b, 3c, 3d) is greater than an error tolerance of one of the sensors (3a, 3b, 3c, 3d).

5. Method according to any of claims 1 to 4, **characterized in that** the second preset value is dependent on the maximum sensor stroke ($H_{max}$).

6. Method according to any of claims 1 to 5, **characterized in that** all changes of the finger positions (5), which are based on a detected movement speed of the finger (2) above a defined maximum movement speed, are not output.

7. Method according to claim 6, **characterized in that** the maximum movement speed is adapted on the basis of a global start value in a self-learning, user-specific manner.

8. Method according to any of claims 1 to 7, **characterized in that** if the difference ($\Delta$(min, max)) between the maximum and minimum sensor stroke ($H_{max}$, $H_{min}$) of the sensors (3a, 3b, 3c, 3d) of two successive finger positions (5) is greater in each case than the first preset value, the comparison of the sensor stroke ($H_{upper}$) with the second preset value is omitted for the last finger position and the output takes place.

9. Method according to claim 8, **characterized in that** the comparison of the sensor stroke ($H_{upper}$) with the second preset value is only omitted in a predefined operating direction of the operating element.

10. Touch-sensitive operating element (1) for carrying out a method according to any of claims 1 to 9, comprising a computing unit (6) and comprising a plurality of capacitive sensors (3a, 3b, 3c, 3d) which are arranged in a row and which can preferably be operated in a direction of movement from top to bottom, and vice versa, when used as intended.

**Revendications**

1. Procédé permettant l'évaluation de signaux d'entrées effectuées par l'intermédiaire d'un doigt (2) sur un élément de commande (1) capacitif tactile, comprenant au moins deux capteurs capacitifs (3a, 3b, 3c, 3d), dans lequel une position de doigt (5) est calculée à partir de courses de capteur (H) de capteurs capacitifs (3a, 3b, 3c, 3d) individuels détectées au même moment, dans lequel la position de doigt (5) calculée n'est pas émise si une différence ($\Delta$(min, max)) entre les courses de capteur maximale et minimale ($H_{max}$, $H_{min}$) des capteurs (3a, 3b, 3c, 3d) est inférieure à une valeur de consigne, **caractérisé en ce que**

   la position de doigt (5) est émise
   si la différence ($\Delta$(min, max)) entre les courses de capteur maximale et minimale ($H_{max}$, $H_{min}$) des capteurs (3a, 3b, 3c, 3d) est supérieure à la première valeur de consigne et
   la course de capteur ($H_{upper}$) d'un capteur (3a) le plus proche de la position de doigt (5) détectée au niveau du bord de l'élément de commande (1) capacitif tactile est inférieure à une seconde valeur de consigne.

2. Procédé selon la revendication 1, **caractérisé en ce que** la différence ($\Delta$(min, max)) admissible entre les courses de capteur maximale et minimale ($H_{max}$, $H_{min}$) des capteurs (3a, 3b, 3c, 3d), à partir de laquelle aucune émission n'est réalisée, est d'autant plus petite que la première valeur de consigne est plus petite.

3. Procédé selon la revendication 1 ou 2, **caractérisé en ce que** la première valeur de consigne dépend de la course de capteur minimale ($H_{min}$).

4. Procédé selon l'une des revendications 1 à 3, **caractérisé en ce que** la première valeur de consigne dépend d'une tolérance aux erreurs d'un des capteurs (3a, 3b, 3c, 3d) et la position de doigt (5) n'est émise que si une différence ($\Delta$(min, max)) entre les courses de capteur maximale et minimale ($H_{max}$, $H_{min}$) des capteurs (3a, 3b, 3c, 3d) est supérieure à une tolérance aux erreurs de l'un des capteurs (3a, 3b, 3c, 3d).

**5.** Procédé selon l'une des revendications 1 à 4,
**caractérisé en ce que**
la seconde valeur de consigne dépend de la course de capteur maximale ($H_{max}$).

**6.** Procédé selon l'une des revendications 1 à 5,
**caractérisé en ce que**
toutes les modifications des positions de doigt (5), lesquelles modifications sont basées sur une vitesse de déplacement du doigt (2) détectée se trouvant au-dessus d'une vitesse de déplacement maximale définie, ne sont pas émises.

**7.** Procédé selon la revendication 6,
**caractérisé en ce que**
la vitesse de déplacement maximale est ajustée de manière individuelle à l'utilisateur et de manière auto-adaptive sur la base d'une valeur de départ globale.

**8.** Procédé selon l'une des revendications 1 à 7,
**caractérisé en ce que**
si la différence ($\Delta(min, max)$) entre les courses de capteur maximale et minimale ($H_{max}$, $H_{min}$) des capteurs (3a, 3b, 3c, 3d) de deux positions de doigt (5) successives est respectivement supérieure à la première valeur de consigne, la comparaison de la course de capteur ($H_{upper}$) avec la seconde valeur de consigne pour la dernière position de doigt est supprimée et l'émission est réalisée.

**9.** Procédé selon la revendication 8,
**caractérisé en ce que**
la comparaison de la course de capteur ($H_{upper}$) avec la seconde valeur de consigne est supprimée uniquement dans un sens de commande prédéfini de l'élément de commande.

**10.** Élément de commande (1) tactile pour la mise en oeuvre d'un procédé selon l'une des revendications 1 à 9, comportant une unité de calcul (6) et comportant plusieurs capteurs capacitifs (3a, 3b, 3c, 3d) disposés en une rangée, lesquels, lorsqu'ils sont utilisés comme prévu, peuvent être commandés de préférence dans un sens de déplacement de haut en bas et inversement.

Fig. 1

Fig. 2

Fig. 3

Fig. 4

Fig. 5

| Bedienschritt | 1.1 | 1.2 | 1.3 | 1.4 | 1.5 |
|---|---|---|---|---|---|
| Fingerbewegung (berechnet) | N/A | + | + | - | - |
| Fingerbewegung (Ist) | N/A | - | - | - | - |
| Hmin>f1* $\Delta$ [min, max] | FALSE | TRUE | FALSE | FALSE | FALSE |
| Hupper< f2*Hmax | TRUE | FALSE | FALSE | TRUE | TRUE |
| Unterdrückung Ausgabe | FALSE | TRUE | TRUE | FALSE | FALSE |
| Fingerbewegung (Ausgabe) | N/A | N/A | N/A | - | - |

## Fig. 6

| Bedienschritt | 2.1 | 2.2 | 2.3 | 3.1 | 3.2 | 3.3 |
|---|---|---|---|---|---|---|
| Fingerbewegung (berechnet) | - | - | - | + | + | + |
| Fingerbewegung (Ist) | - | - | - | + | + | + |
| Hmin>f1* $\Delta$ [min, max] | FALSE | FALSE | FALSE | FALSE | FALSE | FALSE |
| Hupper< f2*Hmax | TRUE | TRUE | TRUE | TRUE | TRUE | (FALSE) |
| Unterdrückung Ausgabe | FALSE | FALSE | FALSE | FALSE | FALSE | FALSE |
| Fingerbewegung (Ausgabe) | - | - | - | + | + | + |

## Fig. 7

Fig. 8

**IN DER BESCHREIBUNG AUFGEFÜHRTE DOKUMENTE**

**In der Beschreibung aufgeführte Patentdokumente**

- US 2010022909 A1
- DE 102012204921 A1
- WO 2014143200 A1
- US 2014160060 A1